(19) Europäisches Patentamt
European Patent Office
Office européen des brevets

(11) **EP 4 298 074 B1**

(12) **EUROPEAN PATENT SPECIFICATION**

(45) Date of publication and mention
of the grant of the patent:
**15.01.2025  Bulletin 2025/03**

(21) Application number: **22710151.6**

(22) Date of filing: **22.02.2022**

(51) International Patent Classification (IPC):
**C04B 35/01** (2006.01)

(52) Cooperative Patent Classification (CPC):
(C-Sets available)
**C04B 35/01; B32B 18/00; C04B 35/62802;**
**C04B 37/006; C04B 41/009; C04B 41/5155;**
**C04B 41/88; C22C 1/1036; C22C 29/065;**
C04B 2111/00362; C04B 2235/3826;
C04B 2235/428; C04B 2235/616; C04B 2235/661;
C04B 2237/083;                                   (Cont.)

(86) International application number:
**PCT/IB2022/051546**

(87) International publication number:
**WO 2022/180510 (01.09.2022 Gazette 2022/35)**

(54) **METHOD FOR MAKING A BRAKING BAND OF A BRAKE DISC, METHOD FOR MAKING THE BRAKE DISC, BRAKE DISC, AND BRAKING BAND FOR BRAKE DISC**

VERFAHREN ZUM HERSTELLEN EINER BREMSSCHEIBE EINER SCHEIBENBREMSE,
VERFAHREN ZUM HERSTELLEN DER SCHEIBENBREMSE, SOWIE BREMSSCHEIBE FÜR EINE
SCHEIBENBREMSE

PROCÉDÉ DE FABRICATION D'UN DISQUE D'UN FREIN À DISQUE, PROCÉDÉ DE FABRICATION
DU FREIN Ä DISQUE ET DISQUE DE FREIN POUR UN FREIN À DISQUE

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**

(30) Priority: **25.02.2021  IT 202100004454**

(43) Date of publication of application:
**03.01.2024  Bulletin 2024/01**

(73) Proprietors:
• **Brembo S.p.A.**
  **24035 Curno (Bergamo) (IT)**
• **ENEA - Agenzia nazionale per le nuove**
  **tecnologie,**
  **l'energia e lo sviluppo economico sostenibile**
  **00196 Roma (IT)**

(72) Inventors:
• **MILANESI, Andrea**
  **24035 Curno,  Bergamo (IT)**
• **MAGNANI, Giuseppe**
  **00196  Roma (IT)**
• **BURGIO, Federica**
  **00196  Roma (IT)**

(74) Representative: **De Lorenzo, Danilo**
**Jacobacci & Partners S.p.A.**
**Piazza della Vittoria, 11**
**25122 Brescia (IT)**

(56) References cited:
**JP-A- H 109 301          US-A- 5 298 283**
**US-A- 5 667 742          US-A1- 2016 108 980**
**US-A1- 2017 001 917     US-A1- 2019 162 263**

(52) Cooperative Patent Classification (CPC): (Cont.)
C04B 2237/363; C04B 2237/365; C04B 2237/60;
C04B 2237/61

C-Sets
**C04B 41/009, C04B 35/565, C04B 38/00;
C04B 41/5155, C04B 41/4523, C04B 41/4572**

**Description**

FIELD OF APPLICATION

This invention relates to a method for making a braking band for a brake disc, a method for making a brake disc, a brake disc, and a braking band for a brake disc made by the aforesaid method.

PRIOR ART

A brake disc of a disc braking system of a vehicle comprises an annular structure, or braking band, and a central fixing element, known as a bell, by means of which the disc is attached to the rotating part of a vehicle suspension, for example a hub. The braking band is provided with opposing braking surfaces suitable for cooperating with friction elements (brake pads), housed in at least one gripper body placed astride said braking band and integral with a non-rotating component of the vehicle suspension. The controlled interaction between the opposing brake pads and the opposing braking surfaces of the braking band causes a braking action by friction which allows the vehicle to decelerate or stop.

Generally, the brake disc is made of gray cast iron or steel. In fact, these materials allow good braking performance (especially in terms of limiting wear) to be obtained at relatively low cost. Discs made of carbon or carbon-ceramic materials offer much higher performance, but at a much higher cost.

As an alternative to gray cast iron or steel discs, discs made of aluminum have been proposed in order to reduce the weight of the disc. Aluminum discs are equipped with protective coatings. The protective coating serves on the one hand to reduce the wear on the disc and thus ensures performance similar to cast iron discs, and on the other hand to protect the aluminum base from the temperatures generated during braking, which are well above the softening temperatures of aluminum (200 - 400°C) .

The protective coatings available today and applied to aluminum discs, while offering resistance to wear, are, however, often subject to flaking, which causes said coatings to detach from said disc. This complicates the production process of the disc. In effect, the disc must undergo surface finishing treatments and must also be prepared for connection to the bell.

It is obvious from that which is described above that aluminum or aluminum alloy discs with protective coatings are not currently able to completely replace steel or gray cast iron discs.

However, the lower density of aluminum with respect to both steel and gray cast iron keeps interest in aluminum very high among those in the braking systems industry as an excellent potential substitute for steel and gray cast iron.

In the sector in question, there is therefore a need for aluminum-based brake discs which on the one hand make it possible to exploit the special operational features of aluminum (first and foremost, due to its lower density) and on the other obtain mechanical strength and wear features that are at least comparable to steel or gray cast iron discs. There is also a need to make these discs with production processes that are as simple and economical as possible.

In WO2019/123222A1, a method is described for making aluminum discs with a porous ceramic preform, which is infiltrated with molten aluminum (liquid or semi-solid state). Unfortunately, the disc obtained in this way provides for direct contact between the brake pad and the aluminum-based metal matrix, which generates possible local degradation phenomena on the disc at the points where the aluminum is overheated by friction to its melting point. Also, document US2016108980A1 disclose a metal matrix composite comprising a ceramic preform to be used in a brake disk.

DISCLOSURE OF THE INVENTION

There is therefore a strong need in the industry for aluminum-based brake discs that do not degrade locally and that, on the one hand, make it possible to take advantage of the special operational features of aluminum (primarily lower density), and, on the other, obtain mechanical strength and wear features comparable to steel or gray cast iron discs, while at the same time being made with production processes that are as simple and economical as possible.

Together with the aforesaid requirements, there is also the need to have brake discs with greater resistance to corrosion with respect to cast iron or steel discs and with lower emission of polluting metal particles.

The aforesaid requirements are satisfied by a method for making a braking band of a brake disc, a method for making a brake disc, a brake disc for disc brakes, and a braking band according to the appended independent claims.

The method for making the braking band according to this invention comprises the following steps:

a) preparing a mold having an inner cavity which comprises a first portion of a shape corresponding to the braking band to be made;

b) preparing a band preform comprising a central preform, an upper outer preform and a lower outer preform; the central preform is made of porous ceramic material comprising silicon carbide (SiC); the upper outer preform and the lower outer preform are made of porous ceramic material comprising silicon carbide and infiltrated with silicon (SiC+Si); a carbon barrier layer is interposed between the upper outer preform and the central preform, and between the lower outer preform and the central preform; moreover the preforms have the shape of the braking band to be made;

c) placing the band preform inside the mold at the first portion of said inner cavity;

d) injecting a liquid or semi-solid aluminum alloy within the entire inner cavity of the mold so as to infiltrate, with said aluminum alloy, the central preform of said band preform made of porous ceramic material, obtaining at the first portion an aluminum metal matrix composite reinforced by said central preform that defines the braking band to be made, and so as to fill, with said aluminum alloy, the second portion, obtaining an aluminum alloy fusion that is connected in one piece with the braking band made of metal matrix composite and defines the bell of the brake disc to be made.

Advantageously, for making the band preform, the method comprises the steps of:

a1) preparing a central preform, an upper outer preform, and a lower outer preform, each made of porous ceramic material comprising silicon carbide (SiC) having the shape of the braking band (2) of the brake disc (1) to be made;

a2) infiltrating the upper outer preform and lower outer preform with silicon (Si);

a3) depositing a material in particle form comprising carbon on the central preform to obtain at least one carbon barrier layer made of carbon.

As an alternative to step a3), the method advantageously provides the step a4) of depositing the material in particle form comprising carbon to obtain at least one carbon barrier layer made of carbon on the upper outer preform and the lower outer preform.

Further, as an alternative to steps a3) and a4), the method advantageously comprises the step A5) of depositing on the central preform and the upper outer preform and/or the lower outer preform the material in particle form comprising carbon to obtain at least one carbon barrier layer (C) made of carbon on the central preform and the upper outer preform and/or the lower outer preform.

Further, preferably, the method provides for the step a6) of joining the central preform, the upper outer preform, and the lower outer preform together by interposing silicon at each carbon barrier layer and heating said preforms until a junction is formed between them at the carbon barrier layers, obtaining the band preform.

Advantageously, the junction of the central preform with the upper outer preform and with the lower outer preform is formed due to the fusion of the silicon interposed at each carbon barrier layer, which reacts with the carbon deposited in the barrier to form silicon carbide (SiC). The silicon carbide (SiC) thus formed acts as a junction between the preforms.

According to an embodiment, in step a2), the upper outer preform and the lower outer preform are placed in a crucible coated with a release layer, e.g., based on boron nitride (BN), a predetermined amount of silicon (Si) powder is added to the crucible as a function of the size of the preforms, and the upper outer preform and the lower outer preform are heated to obtain the fusion of the added silicon.

Preferably, the upper outer preform and the lower outer preform are heated to a temperature above the melting temperature of Si (1414°C), at an atmospheric pressure and in inert atmospheres, preferably in an argon atmosphere.

Advantageously, in step a3) or a4) or a5), the step of depositing a material in particle form comprising carbon to obtain at least one carbon barrier layer made of carbon (C) is obtained by chemical vapor deposition.

Preferably, gaseous methane as a carbon precursor is used for chemical vapor deposition; the temperature is from 1100°C to 1300°C, and the pressure is from 10 to 50 millibars.

Advantageously, the contribution of the gas mixture during the chemical vapor deposition step is:

- between 0.4 and 3 standard liters per minute (slm) of methane;
- between 0.2 and 5 standard liters per minute (slm) of hydrogen;
- between 0 and 4 standard liters per minute (slm) of argon;

and the ratio of methane to hydrogen is between 0.3 and 5.

According to variant embodiments, in step a3) or a4) or a5), the step of depositing a material in particle form comprising carbon to obtain at least one carbon barrier layer made of carbon (C) is obtained by sputtering or the physical vapor deposition (PVD) technique, or with the laser cladding technique.

According to variant embodiments, in step a3) or a4) or a5), the step of depositing a material in particle form comprising carbon to obtain at least one carbon barrier layer made of carbon (C) is achieved by a bonding technique using graphite-based glues.

Preferably, in step a6) the method provides for heating the preforms to a temperature of about 1450°C for a time of about 2 hours, interposing a stoichiometric amount of silicon depending on the size of the carbon surface of the preform. Preferably, step d) of placing the aluminum alloy inside the mold is conducted according to a semi-solid or liquid infiltration technique or squeeze casting technique.

Advantageously, the central preform, the lower outer preform, and the upper outer preform are obtained by sequentially subjecting a mass of granules made of ceramic material superficially coated with a polymeric binding composition to molding, possibly dewaxing, and sintering.

Preferably, the sintering is conducted in two separate sintering cycles, wherein a first sintering cycle is conducted at a temperature of not less than 1600°C, preferably about 1800°C, and a second sintering cycle is conducted at a temperature of not less than 2000°C, preferably in the range of 2100°C-2200°C, both in an inert atmosphere.

Further, preferably, in step d), the mold closes over the upper outer preform and the lower outer preform in such a way that, during the injection of aluminum into the mold, the infiltration of aluminum over the upper and lower outer preform is prevented, so that the outer braking surfaces of the braking band are free of aluminum.

The method for making a brake disc comprising a braking band and a bell according to an embodiment of this invention comprises the following steps:

a) preparing a mold having an inner cavity which comprises a first portion of a shape corresponding to the braking band to be made and a second portion of a shape corresponding to the bell of the brake disc to be made, wherein the first and second portions of said inner cavity are communicating with each other;

b) preparing a band preform comprising a central preform, an upper outer preform and a lower outer preform; the central preform is made of porous ceramic material comprising silicon carbide (SiC); the upper outer preform and the lower outer preform are made of porous ceramic material comprising silicon carbide (SiC) and infiltrated with silicon (SiC+Si); a carbon barrier layer is interposed between the upper outer preform and the central preform and between the lower outer preform and the central preform intended to react with the silicon (Si) to act as a junction of the upper and lower outer preforms with the central preform; moreover, said preforms have the same shape as the braking band of the brake disc to be made;

c) placing said band preform within the mold at the first portion of said inner cavity;

d) injecting a liquid or semi-solid aluminum alloy within the entire inner cavity of the mold so as to infiltrate the central preform of said band preform made of porous ceramic material with said aluminum alloy to obtain in the first portion an aluminum metal matrix composite reinforced by said central preform that defines the braking band of the brake disc to be made, and so as to fill the second portion with said aluminum alloy to obtain an aluminum alloy fusion that is connected in one piece with the braking band made of metal matrix composite and defines the bell of the brake disc to be made.

A disc brake according to this invention comprises a braking band and a bell connected to said braking band.

Preferably, in an advantageous way, the bell is connected in one piece with the braking band and is composed of a co-casting made of aluminum alloy with the metal matrix of the composite forming the braking band.

According to this invention, the braking band is composed of a central band made of an aluminum metal matrix composite reinforced by ceramic material comprising silicon carbide (SiC). This composite is obtained by infiltrating a central preform of porous ceramic material having a shape corresponding to the braking band with an aluminum alloy. The braking band is further composed of an upper band and a lower band. The upper band is joined to the central band along an upper junction layer. Said upper band is made of porous ceramic material comprising silicon carbide (SiC) and infiltrated with silicon (SiC+Si) and covers the central band on one of its sides. The lower band is joined to the central band along a lower junction layer arranged opposite, i.e., opposed, to the upper junction layer. The lower band is made of porous ceramic material comprising silicon carbide (SiC) and infiltrated with silicon (SiC+Si) and covers the central band from the other side, i.e., opposed to the upper band.

Preferably, the aluminum alloy matrix has a homogeneously distributed structure within said composite.

## DESCRIPTION OF THE DRAWINGS

Further features and advantages of this invention will become more apparent from the following detailed description of preferred, non-limiting embodiments thereof, wherein:

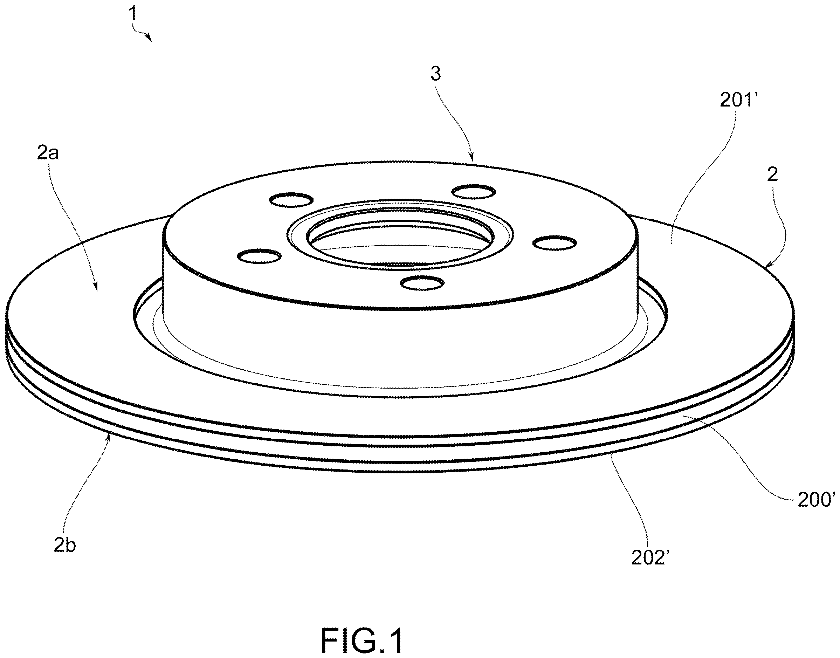

- Fig. 1 is a perspective view of a brake disc according to an embodiment of the present invention;
- Fig. 2 schematically depicts some of the steps of the method, in particular the initial steps for making a braking band for a brake disc according to an embodiment of the present invention;
- Fig. 2a schematically depicts the steps of the method for making a braking band for a brake disc according to a first embodiment of the method of the present invention;
- Fig. 2b schematically depicts the steps of the method for making a braking band for a brake disc according to a second embodiment of the method of the present invention;
- Fig. 2c schematically depicts the steps of the method for making a braking band for a brake disc according to a third embodiment of the method of the present invention;

- Fig. 2d schematically depicts the steps of the method for making a braking band for a brake disc according to a fourth embodiment of the method of the present invention, wherein the step of infiltrating silicon into the upper and lower outer preforms is carried out after a step of mechanically joining the upper and lower preforms with the central preform;
- Fig. 2e schematically depicts the steps of the method for making a braking band for a brake disc according to a fifth embodiment of the method of the present invention, wherein the step of infiltrating silicon into the upper and lower outer preforms is carried out after a step of mechanically joining the upper and lower preforms with the central preform;
- Fig. 2f schematically depicts the steps of the method for making a braking band for a brake disc according to a sixth embodiment of the method of the present invention, wherein the step of infiltrating silicon into the upper and lower outer preforms is accomplished after a step of mechanically joining the upper and lower preforms with the central preform;

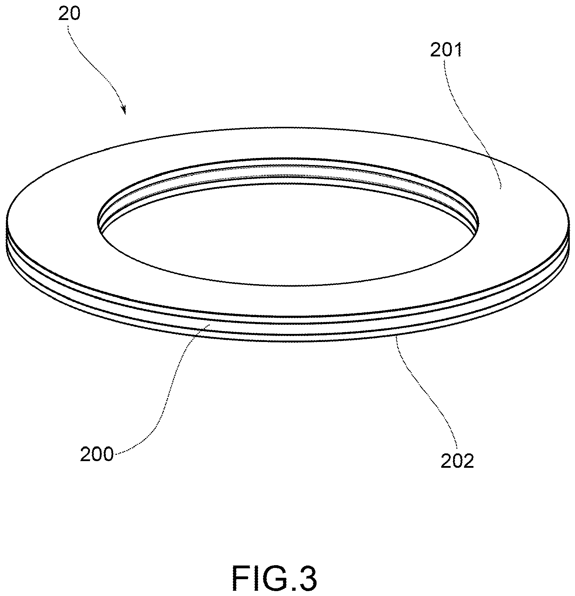

- Fig. 3 is a perspective view of a band preform according to an embodiment of the present invention;

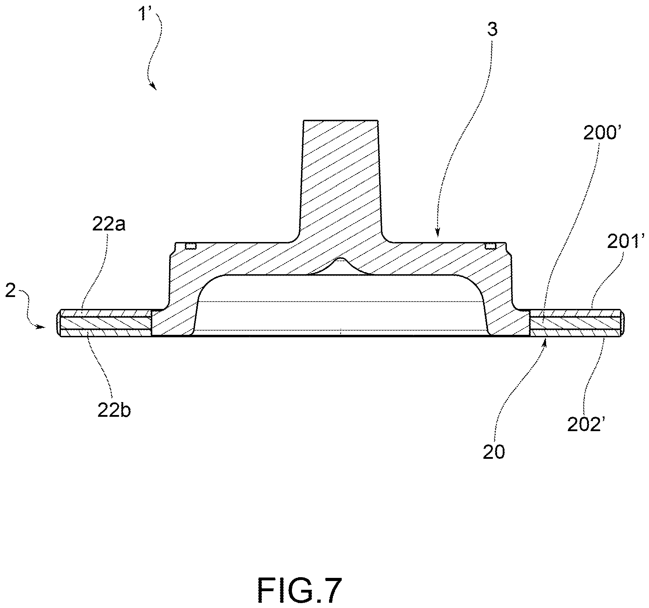

- Fig. 4, 5, 6 and 7 each show a step in the method of making a brake disc according to an embodiment of the present invention, wherein the steps follow each other in order from Fig. 4 to Fig. 7; in particular, Fig. 7 shows the cross section of a rough brake disc made on a diametrical plane of the rough brake disc; the rough brake disc is an intermediate product immediately preceding the final brake disc shown in Fig. 1, said brake disc being obtained by removal of the unnecessary portions of the rough brake disc by subsequent machining.

Elements or parts of elements common to the embodiments described hereinafter will be indicated with the same reference numerals.

DETAILED DESCRIPTION

With reference to the aforesaid figures, reference numeral 1 globally denotes a brake disc according to this invention.

According to a general embodiment of the invention, illustrated in the accompanying figures, the brake disc 1 comprises a braking band 2, provided with two opposing outer braking surfaces 2a and 2b, each of which at least partially defines one of the two main faces of the disc.

The brake disc 1 further comprises a bell 3, which is connected to the braking band 2.

According to a first aspect of the invention, the braking band 2 is composed of a central band 200' made of an aluminum-based metal matrix composite reinforced with ceramic material comprising silicon carbide (SiC).

The aforesaid composite falls under the category of composites known in the industry as MMC (metal matrix composite).

The use of said MMC composite comprising aluminum in the braking band 2 allows mechanical and chemical-physical features to be obtained that are even greater with respect to those of aluminum (see in particular density and thus lightness), and at the same time (with respect to a simple fusion in aluminum or its alloy) adds functional features in a heavy application such as that required in a braking system without needing protective coatings on the braking surfaces.

Further, the braking band 2 is also composed of an upper band 201' that is joined to the central band 200' along an upper junction layer 22a. The upper band 201' is made of porous ceramic material comprising silicon carbide (SiC) and infiltrated with silicon (SiC+Si). Further, the upper band 201' covers the central band 200' on one side thereof, so that on said side, the central band 200' is not subjected to contact with the brake pads when the brake disc is mounted on the disc brake.

Additionally, the braking band 2 is composed of a lower band 202' that is joined to the central band 200' along a lower junction layer 22b arranged opposite, i.e., opposed, to the upper central layer 201'. The lower band 202' is also made of porous ceramic material comprising silicon carbide (SiC) and infiltrated with silicon (SiC+Si). Further, the lower band 202' covers the central band 200' on the other side, i.e., opposite to the upper band 201'. In this way, the result is that the central band 200' is sandwiched between the upper band 201' and the lower band 202'. In particular, the outer braking surfaces 2a, 2b of the braking band 2 are each outermost surfaces of the lower band 202' and the upper band 201' which are not joined to the central band 200'.

With respect to a braking band made only with aluminum or one of the alloys thereof, the presence of the reinforcement made of ceramic material in the central band 200' and the presence of the upper band 201' and the lower band 202 allow greater hardness, greater rigidity, a higher friction coefficient, and higher wear resistance to be obtained. All these features make this braking band suitable for use for a brake disc.

In this way it is possible to create a braking band with the advantageous features of aluminum (see in particular the lower density with respect to steel and cast iron), but at the same time avoiding the need to provide the braking surfaces with protective coatings, and the limitations and inconveniences thereof, both productive and operational.

The aforesaid ceramic material from which the reinforcement is made is silicon carbide.

As will be taken up later in the description, the MMC composite forming the central band 200' is obtained by infiltrating a porous ceramic material preform with an aluminum alloy. Advantageously, the ceramic materials listed above, including silicon carbide, are able to withstand the step of infiltrating by the molten metal without altering their chemical and physical structure and without being damaged macroscopically and microscopically to any extent. For this reason, too, they are particularly suitable for making the aforesaid composite.

Preferably, the aluminum alloy is chosen from the group composed of alloys suitable for fusion processes, preferably containing at least silicon, at least manganese, at least magnesium.

An advantageous embodiment provides that the aluminum alloy has a high magnesium (Mg) content, more preferably with high magnesium and silicon (Si) content.

Preferably, the magnesium (Mg) content is less than 15%, even more preferably less than 10% but at least 0.2%. This provides increased mechanical properties and machinability on machine tools, as well as ensuring increased corrosion resistance and an improved ability of the alloy to fill complex mold shapes by lowering the surface tension of the alloy in the liquid state. Preferably, the aluminum alloy is AlSi13Mg9Ti alloy.

Advantageously, the aluminum alloy matrix has a homogeneously distributed structure within the composite. As will be discussed below, this may be achieved by infiltrating with aluminum alloy a preform made of porous ceramic material having a homogeneous porosity throughout its volume. The aluminum alloy - due to the infiltration process - permeates the porosity of the ceramic material creating a homogeneous structure.

According to another aspect of this invention, the brake disc 1 provides for the aforesaid bell 3 to be connected in one piece with the braking band 2 and is composed of an aluminum alloy co-casting with the metal matrix of the composite forming the braking band 2.

As will be taken up hereinafter in the description, in this variant the bell 3 is obtained in the same mold wherein the infiltration with aluminum alloy of the preform in ceramic material is carried out, using the same aluminum alloy. In this way, in the same operating step, the forming of the composite material and the fusion of the bell are obtained, achieving a complete joint of the two materials.

Making the bell in co-casting with the braking band allows for the production process to be significantly simplified. In fact, it avoids the need to set up both a dedicated production line to produce the bell and an assembly line for assembling the bell on the band.

The combination of the aforesaid two essential aspects of the invention makes it possible to have aluminum-based brake discs that make it possible on the one hand to exploit the special operational features deriving from aluminum (first and foremost the lower density) and on the other hand to have mechanical and wear resistance features comparable to steel or gray cast iron discs, and at the same time may be made with production processes that are as simple and economical as possible.

It is obvious that, according to an embodiment, the braking band 2 according to this invention is also connectable with a bell 3 which is not co-fused (or made in one piece) but is connected through bell-band connection means according to the prior art (assembly, interference fitting, riveting, and the like).

In other words, once only the braking band 2 has been made, it is suitable to be assembled with the bell 3 in the known manner for making a brake disc, thus obtaining a brake disc, for example, by floating compound or interference fitting.

Therefore, it is understood that in this discussion, the intention is also to protect a method of making the brake disc comprising also a final step of the method wherein there is provided a connection between the braking band 2 according to this invention and the bell 3 not in one co-fused piece but through bell-band connection means, for example by assembly, interference fitting, riveting, and the like.

For simplicity of discussion, the braking band 2 and the brake disc 1 will now be described contextually with their respective methods of fabrication according to this invention. The brake disc 1 is preferably, but not necessarily, made with the method according to the invention which will now be described.

According to a general embodiment of the method according to the invention, the method for making the brake disc 1 comprises a first operating step a) for preparing a mold 10 having an inner cavity 11 comprising a first portion 11a of a shape corresponding to the braking band 2 of the brake disc 1 to be made and a second portion 11b of a shape corresponding to the bell 3 of the brake disc 1 to be made.

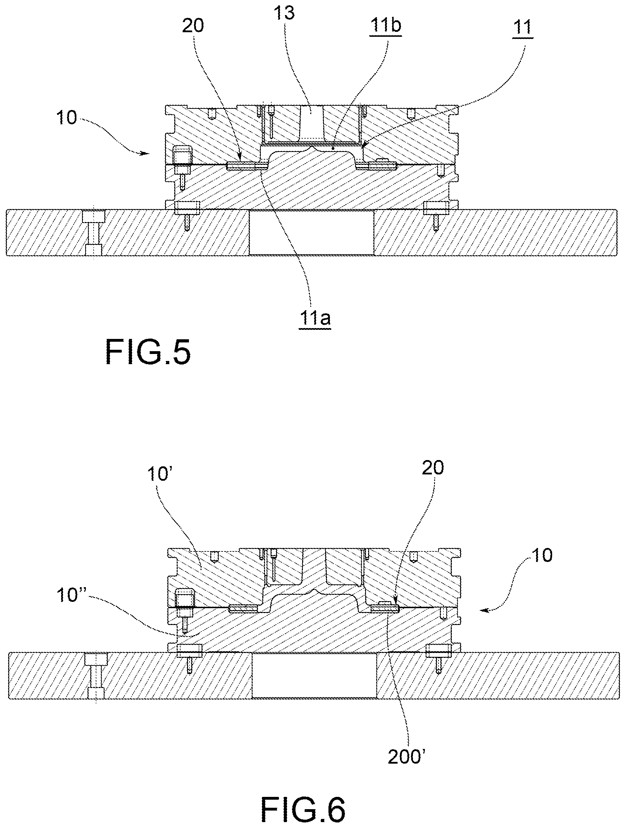

The first portion 11a and the second portion 11b of said inner cavity 11 communicate with each other, as illustrated in Fig. 5 and 6, which schematically illustrate an example of a mold usable in the context of the method according to the invention.

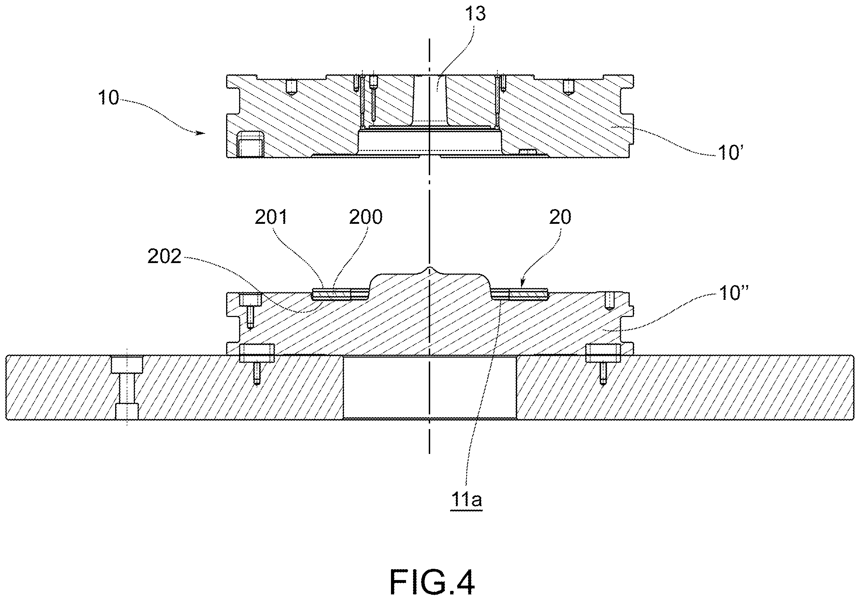

Advantageously, as illustrated in Fig. 4 and 5, the mold comprises one or more inlet openings 13 for injecting the aluminum alloy directly into the second portion of the inner cavity 11 of the mold 10. Said inlet opening 13 develops coaxially to the circumferential development of the second portion 11b of a shape corresponding to the bell 3 of the brake disc 1 to be made. Operationally, the injection of the aluminum alloy may therefore be made from the inlet opening 13, from which it subsequently propagates into the first portion 11a.

The method comprises a second operating step b) of preparing a band preform 20 comprising a central preform 200, an upper outer preform 201, and a lower outer preform 202. Said central preform 200 is made of porous ceramic material comprising silicon carbide (SiC). Further, the upper outer preform 201 and the lower outer preform 202 are made of porous ceramic material comprising silicon carbide (SiC) and infiltrated with silicon (SiC+Si). A carbon barrier layer 201a, 200a, 200b, 202a made of carbon is interposed between the upper outer preform 201 and the central preform 200 and between the lower outer preform 202 and the central preform 200.

Advantageously, said carbon barrier layer 201a, 200a, 200b, 202a made of carbon allows for making the joint between the preforms 200, 201, 202 more stable and reliable and to act as an auxiliary barrier layer in the step of infiltrating aluminum into the central preform 200, so as to further limit the possibility of aluminum infiltrating the upper outer preform 201 and the lower outer preform 202. The aforesaid preforms 200, 201, 202 have a shape substantially the same as the shape of the braking band 2 of the brake disc 1 to be made.

The method further comprises the following additional operating steps:

c) placing the aforesaid band preform 20 within the mold at the first portion 11a of said inner cavity 11; and
d) injecting a liquid or semi-solid aluminum alloy within the entire inner cavity 11 of the mold 10.

The injection of the aluminum alloy is conducted so as to infiltrate with the aforesaid aluminum alloy the central preform 200 of said band preform 20, obtaining in the first portion 11a an aluminum-based metal matrix composite reinforced by the central preform 200 which partially defines the braking band 2 of the brake disc to be made, and in such a way as to fill the second portion 11b with the aforesaid aluminum alloy, obtaining an aluminum alloy fusion which is connected in one piece with the braking band 2 made of metal matrix composite, and defines the bell 3 of the brake disc 1 to be made.

According to a general embodiment, the method for making a braking band 2 for a brake disc 1 comprises a sequence of steps similar to the steps of the method for making the brake disc, except for the fact that the mold 10 is shaped for making only the braking band 2 and not for making the bell 3. Consequently, with respect to the steps of the method for making the brake disc, in step a) the mold does not comprise a second portion 11b of a shape corresponding to the bell 3 of the brake disc 1 to be made. Further, with respect to the method for making the brake disc 1, in step d), the infiltration of the aluminum alloy is conducted only so as to infiltrate the central preform 200 of said band preform 20 with the aforesaid aluminum alloy, obtaining in the first portion 11a an aluminum-based metal matrix composite reinforced by the central preform 200 that partially defines the braking band 2 of the brake disc to be made. It is apparent that, for making the braking band only, it is not necessary to provide for the aluminum alloy to fill the second portion 11b, since the simultaneous production of the bell of the brake disc 2 by co-casting is not required. Although the mold for the method for making the braking band is not depicted in the appended figures, how to modify the aforesaid mold 10 so that it is free of the second portion 11b intended for making the bell may be clearly and unequivocally derived by a person skilled in the art.

Thus, in a general embodiment, the method for making the braking band according to this invention comprises a first operating step a) of preparing a mold 10 having an inner cavity 11 comprising a first portion 11a of a shape corresponding to the braking band 2 of the brake disc 1 to be made.

Also in this case, the mold comprises one or more inlet openings 13 for injecting the aluminum alloy directly into the second portion of the inner cavity 11 of the mold 10.

The method comprises a second operating step b) of preparing a band preform 20 comprising a central preform 200, an upper outer preform 201, and a lower outer preform 202. Said central preform 200 is made of porous ceramic material comprising silicon carbide (SiC). In addition, the upper outer preform 201 and the lower outer preform 202 are made of porous ceramic material comprising silicon carbide (SiC) and infiltrated with silicon (SiC+Si). A carbon barrier layer 201a, 200a, 200b, 202a made of carbon is interposed between the upper outer preform 201 and the central preform 200 and between the lower outer preform 202 and the central preform 200. Said preforms 200, 201, 202 have a shape substantially the same as the shape of the braking band 2 of the brake disc 1 to be made.

The method further comprises the following additional operating steps:

c) placing the aforesaid band preform 20 within the mold at the first portion 11a of said inner cavity 11; and
d) injecting a liquid or semi-solid aluminum alloy within the entire inner cavity 11 of the mold 10.

The injection of the aluminum alloy is conducted so as to infiltrate with the aforesaid aluminum alloy the central preform 200 of said band preform 20, obtaining at the first portion 11a an aluminum metal matrix composite reinforced by the central preform 200 that partially defines the braking band 2 of the brake disc to be made.

Advantageously, for producing the brake disc 1 as well as for producing the braking band 2, step b) of injecting the aluminum alloy within the mold may be conducted following any technique fit for the purpose.

In particular, step b) may be conducted according to a liquid-state infiltration technique, according to a squeeze casting technique, according to a gravity infiltration technique, or according to a semi-solid-state infiltration technique, or by die casting with liquid aluminum.

In the case of gravity infiltration, the infiltration preferably takes place in an inert atmosphere, such as a nitrogen atmosphere.

The aforesaid infiltration techniques are well known to a person skilled in the art and will therefore not be described here.

Preferably, step b) of injecting the aluminum alloy inside the mold is conducted according to a semi-solid infiltration technique. In fact, it has been found that this technique is more suitable for infiltrating ceramic preforms so that at the end of the process the resulting disc made of MMC material has homogeneous features throughout its structure. At the same time, this technique is suitable for forming the bell within the same process.

More specifically, infiltration at the semi-solid stage occurs at a temperature between the liquidus and solidus line of the aluminum alloy used, i.e., with the alloy in a semi-solid state. Due to the low viscosity of the semi-solid mass, the process of injection into the mold and infiltration occurs smoothly and with low turbulence.

That which is particularly advantageous is that the presence of the upper outer band and the lower outer band, infiltrated with silicon, prevents aluminum from infiltrating said upper and lower outer bands. The result is a pair of opposing braking surfaces 2a, 2b that are particularly suitable for use in a brake disc, as they are free of aluminum and have improved friction coefficients with respect to the prior art for aluminum discs. In addition, the further presence of the carbon barrier layer ensures even more advantageously that aluminum migration from the central preform to the upper and lower outer preforms does not occur during the aluminum infiltration step.

According to a preferred embodiment of the method for making the braking band 2 or the method for making the brake disc 1, the aforesaid band preform 20 made of porous ceramic material is obtained by subjecting a mass of ceramic material granules, superficially coated with a polymeric binding composition, to the following sequential operating steps: molding, debonding (or dewaxing), and sintering.

Advantageously, the aforesaid ceramic material granules are powder granules known as "ready-to-press." This kind of commercially available powder allows "net shape molded" products to be obtained, without the need of other components or additives besides said powder.

Preferably, the aforesaid ceramic material from which the granules are formed is silicon carbide.

Preferably, the polymeric binding composition that coats the ceramic material granules is chosen from the group consisting of thermoplastic and thermosetting polymers.

Preferably, the molding of the mass of ceramic material granules is done uniaxially or isostatically or using any other technique that allows for a preform of such a size and shape to be obtained.

At the end of the molding process, an aggregate of the aforesaid ceramic material granules is obtained, connected by ceramic microstructures facilitated by the respective coatings of polymeric binding composition. Said aggregate contains organic residues from the granule coatings. These organic residues are removed in the debonding (or dewaxing) step.

Advantageously, debonding is conducted under air flow conditions at a temperature below 700°C until the organic phase present in the mass of ceramic material granules after molding is fully eliminated.

According to a variant, debonding is conducted under inert atmospheric conditions.

At the end of the debonding step, a green body is obtained, consisting essentially only of ceramic material. This green body is then subjected to the sintering phase that transforms the green body into a continuous structure obtained by the formation of bridges connecting the individual ceramic particles. This results in a body that exhibits homogeneous properties throughout the structure.

Preferably, the sintering is conducted in two separate sintering cycles. A first sintering cycle is conducted at a temperature of not less than 1600°C, preferably about 1800°C, and a second sintering cycle is conducted at a temperature of not less than 2000°C, preferably in the range of 2100°C-2200°C, both under an inert atmosphere.

Advantageously, the resulting band preform 20 made of porous ceramic material has a homogeneous distribution of density and porosity throughout its volume. Said features make the preform suitable for making a homogeneously distributed aluminum alloy matrix following its infiltration with said alloy.

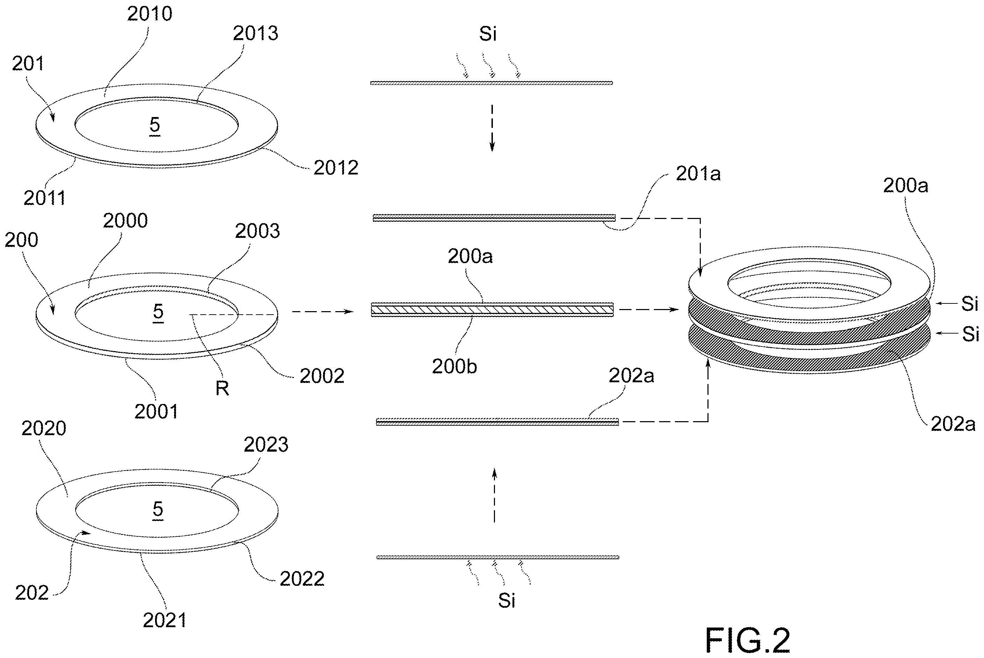

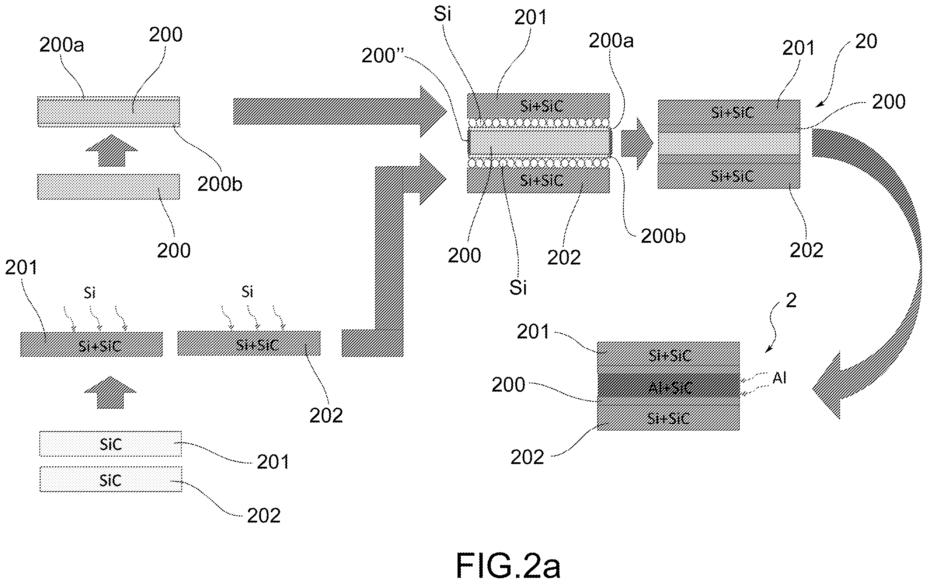

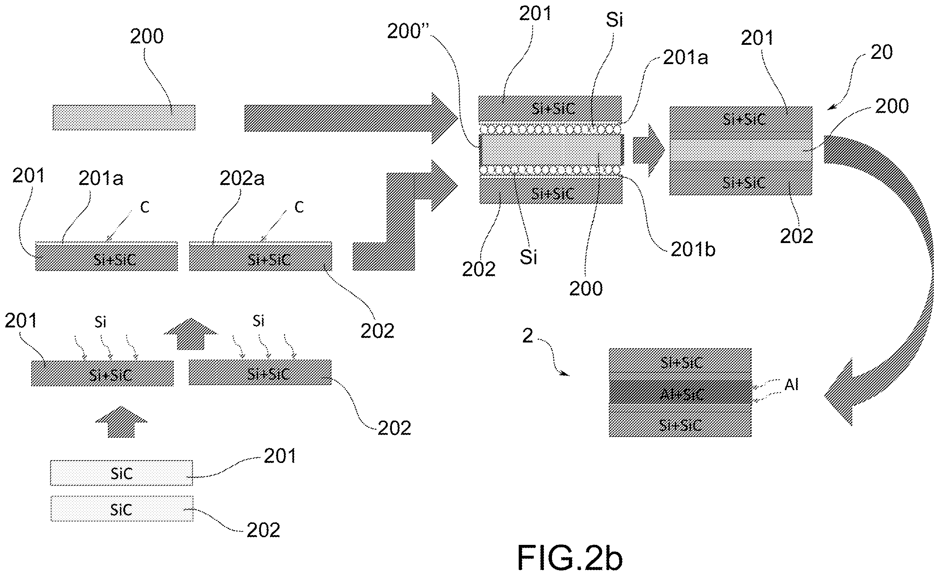

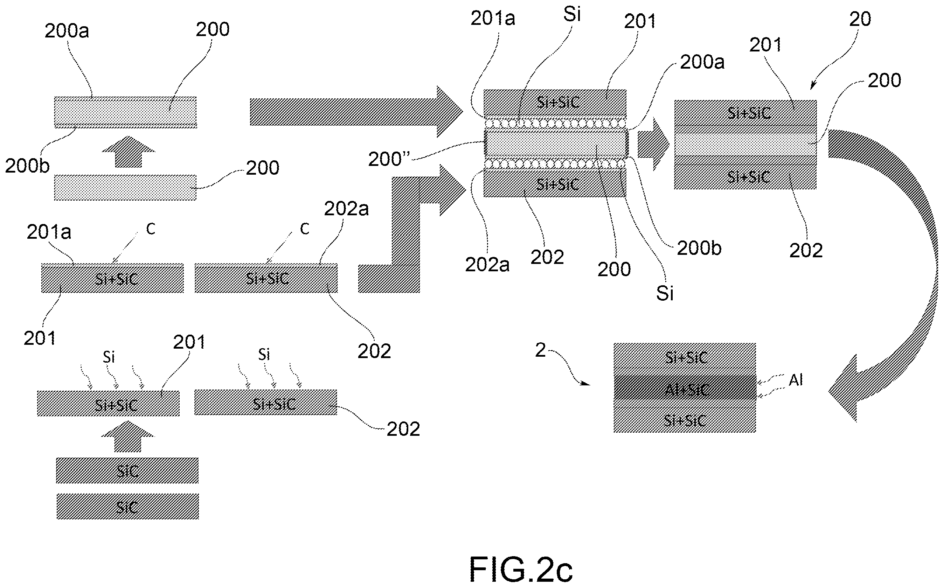

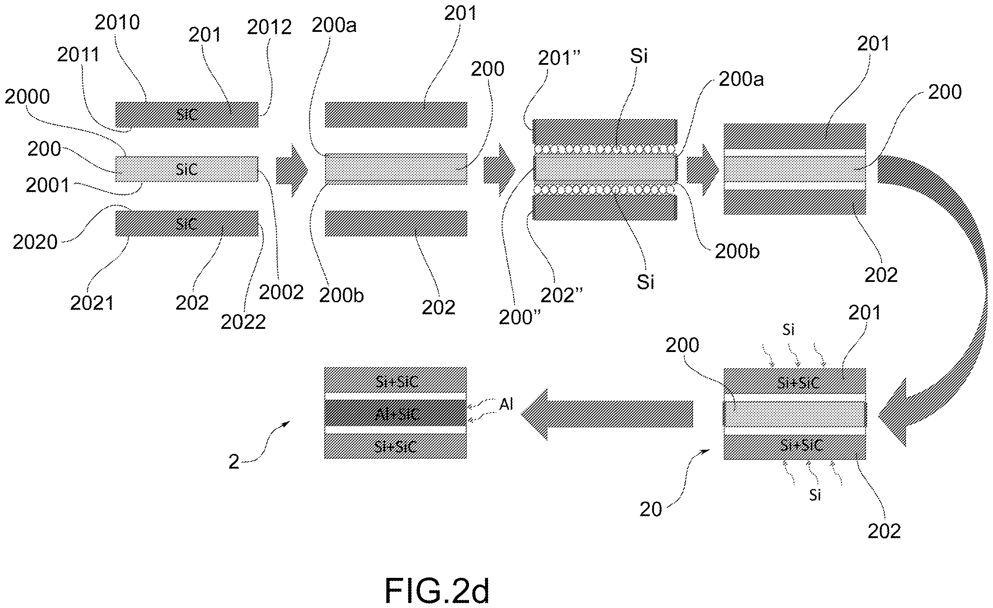

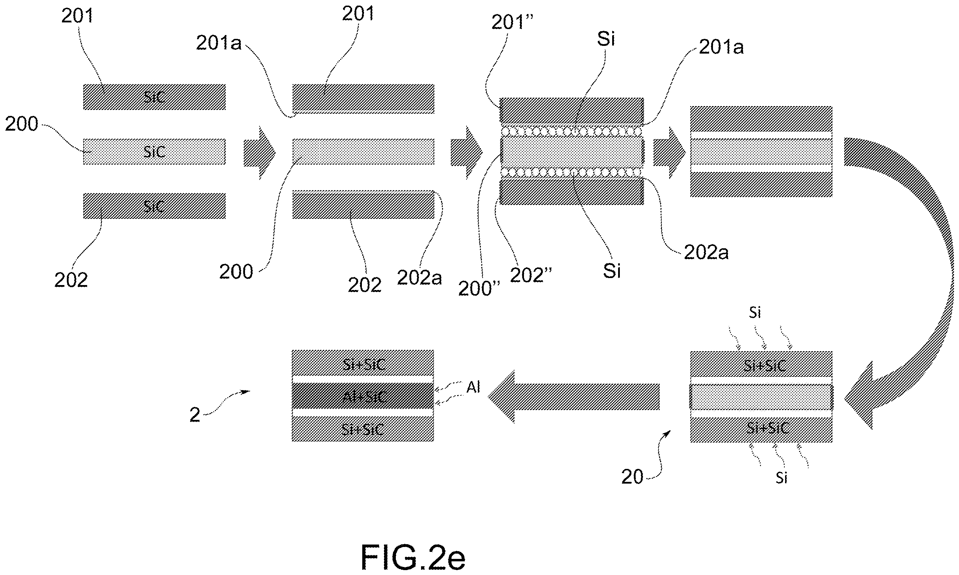

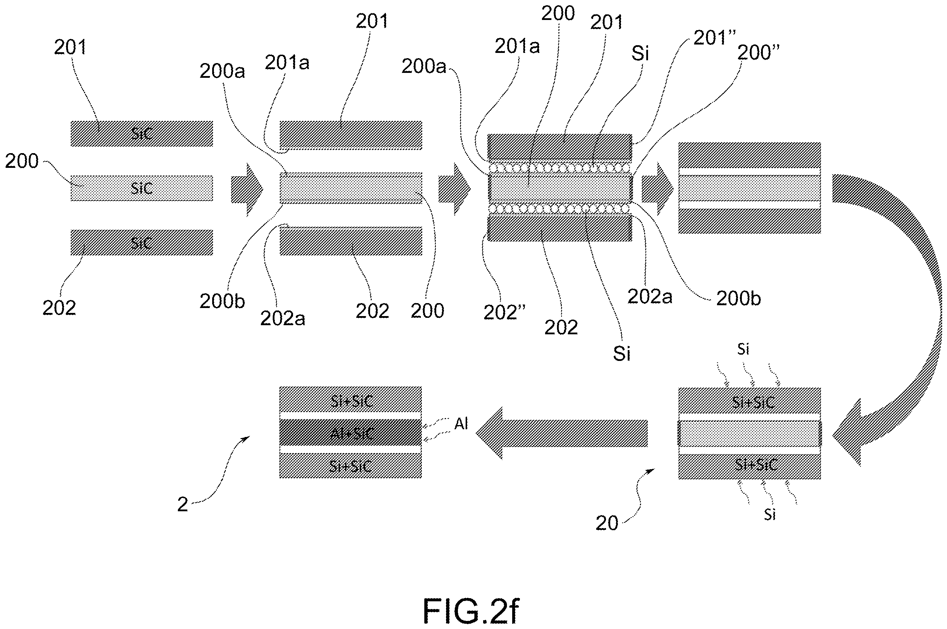

According to an advantageous embodiment, both the method for making the braking band and the method for making the brake disc comprise a sequence of operating steps to be executed before step b), for example illustrated schematically in Fig. 2, 2a, 2b, 2c. In particular, the aforesaid sequence of operating steps envisages an initial operating step a1) of preparing a central preform 200, an upper outer preform 201, and a lower outer preform 202. Each of said central preform 200, upper outer preform 201, and lower outer preform 202 is made of porous ceramic material comprising silicon carbide (SiC). Said preforms each have a shape such that, when joined, they assume, together, a shape substantially equal to the braking band 2 of the brake disc 1 to be made.

Additionally, the aforesaid sequence of operating steps provides for a subsequent operating step a2) of infiltrating the upper outer preform 201 and the lower outer preform 202 with silicon (Si). Infiltration with silicon prevents there being space for the aluminum to infiltrate the preform in the infiltration step of the aluminum alloy.

Preferably, in this step a2) the upper outer preform 201 and the lower outer preform 202 are placed in a crucible coated with a release layer, for example based on boron nitride (BN), and a predetermined amount of silicon (Si) powder is added to the crucible. Subsequently, the upper outer preform 201 and the lower outer preform 202 are heated to achieve the fusion of the added silicon and, thus, infiltration.

Advantageously, the upper outer preform 201 and the lower outer preform 202 are heated to a temperature above the melting temperature of Si (1414°C), at an atmospheric pressure and in inert atmospheres, preferably in an argon atmosphere. The process may be accomplished using appropriately sized industrial furnaces.

According to a variant, the upper outer preform 201 and/or the lower outer preform 202 are heated to a temperature above the melting temperature of Si (1414°C) at a pressure other than atmospheric pressure, for example even in a controlled vacuum.

Additionally, preferably, following the infiltration process, the upper and lower outer preforms are optionally leveled (ground) before being subjected to the subsequent steps described below.

The aforesaid sequence of operating steps provides for a further operating step a3) of depositing on the central preform 200 a material in particle form comprising carbon to obtain at least one carbon barrier layer 200a, 200b made of carbon, as for example shown in Fig. 2a.

As an alternative to step a3), a step a4) may be provided to deposit on the upper outer preform 201 and lower outer preform 202 a material in particle form comprising carbon to provide at least one carbon barrier layer 201a, 202a made of carbon (C) on each of the upper outer preform 201 and lower outer preform 202, as for example shown in Fig. 2b.

Additionally, as an alternative to steps a3) and a4), a step a5) may be provided to deposit on the central preform 200 and upper outer preform 201 and/or lower outer preform 202 a material in particle form comprising carbon to achieve at least one carbon barrier layer 200a and/or 200b, 201a and/or 202a made of carbon (C) on the central preform 200 and upper outer preform 201 and/or lower outer preform 202, as for example shown in Fig. 2c.

In other words, preferably in any variant of the method described herein, a carbon barrier layer may be created between the upper outer preform 201 and the central preform 200 and between the lower outer preform 202 and the central preform 200, either by providing for a deposition exclusively on the upper and lower outer preforms, or by providing for a deposition exclusively on two opposing faces 2000, 2001 of the central preform, or by providing for a deposition on both the central preform 200 and the upper outer preform 201 and lower outer preform 202.

It is obvious that, preferably, the carbon barrier layer (and thus its deposition) is created only on one of the two opposing faces 2010, 2011; 2020, 2021 of each of the upper and lower outer preforms.

It is also obvious that, preferably, the central preform 200, the upper outer preform 201, and the lower outer preform 202 have an annular disc shape, preferably with a central through hole 5. Preferably, the two opposing faces 2000, 2001; 2010, 2011; 2020, 2021 are the two opposing faces of the disc shape having the greatest extension.

The two opposing faces 2000, 2001; 2010, 2011; 2020, 2021 of each preform, therefore, comprise an upper face 2000; 2010; 2020 and an opposing lower face 2001; 2011; 2021, joined together by a side wall 2002; 2012; 2022 that develops incidentally, preferably perpendicularly, to the upper faces 2000; 2010; 2020 and lower faces 2001; 2011; 2021, i.e., forming the shell of the disc.

Preferably, in the case wherein each preform is already provided with a central through-hole 5, it is obvious that said preform will thus also have an inner side wall 2003; 2013; 2023, opposing the side wall 2002; 2012; 2022.

The aforesaid sequence of operating steps provides for a further subsequent operating step a6) of joining together the central preform 200, the upper outer preform 201, and the lower outer preform 202 by interposing silicon (Si) at each carbon barrier layer 200a and/or 200b, 201a and/or 202a and heating said preforms 200, 201, 202 until a joint is formed between them at the carbon barrier layers 200a and/or 200b, 201a and/or 202a, thereby obtaining the band preform 20. Preferably, therefore, silicon (Si), e.g., solid silicon, is interposed between each carbon barrier layer 200a and/or 200b, and the upper outer preform 201 and the lower outer preform 202, or between each carbon barrier layer 201a and/or 202a and the central preform 200, or between each carbon barrier layer 200a and/or 200b and the corresponding facing carbon barrier layer 201a and/or 202a.

Advantageously, said step a6) of creating the junction between the central preform 200 and the upper outer preform 201 and lower outer preform 202 provides for heating the preforms 200, 201, 202 to a temperature of about 1450°C for a time of about 2 hours by interposing a stoichiometric amount of silicon between the preforms as a function of the size of said preforms.

For example, the stoichiometric amount of silicon (MSi) may be calculated as follows. Once the total volume of carbon is defined:

$VC = \pi(R2-r2)h$, where the radii R and r are the outer radius R and inner radius r, respectively, of the circular crown described by the preform 200, 201, or 202, and h is the thickness of the carbon barrier layer (assuming the layer is compact and free of porosity);
it is possible to calculate the mass of carbon C deposited as
$MC = VC \times Dc$, where Dc is the carbon density.

Given the formula Si + C = SiC, knowing that 1 mole of silicon (Si) reacts with 1 mole of carbon (C) to generate one mole of silicon carbide (SiC), and the atomic weights of the components being known, it is possible to calculate stoichiometric amounts of silicon as:

$$MSi = MC \times atomic\ weight\ Si\ /\ atomic\ weight\ C.$$

For example, in the case where the preforms have a diameter of about 40 millimeters and the amount of Si needed is about 3 grams, said parameters allow an adequate and reliable junction between the preforms to be obtained.

It is obvious that, depending on the process adopted, once the minimum stoichiometric quantity of Si (MSi) necessary to react with carbon C according to the aforesaid formulas is known, it is possible to optionally proceed by increasing the amount of silicon in order to bring in more or less hyperstoichiometric conditions in order to ensure the completion of the chemical reaction.

Obviously, once the band preform 20 is obtained as described above, the central preform 200 corresponds to the central band 200' of the braking band 20, and the upper outer band 201 and lower outer band 202 correspond to the upper outer band 201' and lower outer band 202' of the braking band 20, respectively.

According to a preferred embodiment, in step a3) or a4) or a5), the step of depositing a material in particle form comprising carbon to obtain at least one carbon barrier layer 200a, 200b, 201a, 202a made of carbon (C) is achieved by chemical vapor deposition.

Preferably, gaseous methane as a carbon precursor is used for chemical vapor deposition, the temperature is 1100°C to 1300°C, and the pressure is 10 to 50 millibars.

Even more preferably, the contribution of the gas mixture during the chemical vapor deposition step is:

- between 0.4 and 3 standard liters per minute (slm) of methane;
- between 0.2 and 5 standard liters per minute (slm) of hydrogen;
- between 0 and 4 standard liters per minute (slm) of argon;

and the ratio of methane to hydrogen is between 0.3 and 5.

The aforesaid parameters allow for a carbon barrier layer, that is a carbon coating, to be obtained on the preforms, minimizing as much as possible the risk of infiltration in said preforms.

Advantageously, in step d) of the method according to this invention, as visible, for example, in Fig. 5 to 6, the mold closes over the upper outer preform 201 and the lower outer preform 202 in such a way that during the injection of aluminum into the mold, the infiltration of aluminum over the upper 201 and lower 202 outer preform is prevented, so that the outer braking surfaces 2a,2b of the disc are free of aluminum. In other words, the aluminum alloy is prevented from flowing and creeping above the upper 201 and lower 202 outer preform, i.e., on the side of each outer preform 201, 202 not joined to the central preform 200.

According to a variant of the method, appreciable more clearly in Fig. 2d, 2e, and 2f, the execution of the operating step a2) for infiltrating the upper outer preform 201 and lower outer preform 202 with silicon (Si) prior to executing step a6) as described above is not envisaged. In this variant of the method, however, after step a1) and after steps a3) or a4) or a5), previously described, the method initially comprises the operating step a11) of protecting one or more regions of the upper outer preform 201, the lower outer preform 202, and the central preform 200 with a release layer 200", 201", and 202", preferably based on boron nitride (BN), and then subsequently executing step a6), as described above. The 200", 201", and 202" release layer prevents the infiltration of silicon (Si) through the release layer into the regions to be protected. This is for example obtained with a boron nitride-based release layer.

Preferably, in this step a11) protection of one or more regions of the upper outer preform 201, the lower outer preform 202, and the central preform 200 is achieved by placing the aforesaid preforms 200, 201, 202 in a crucible coated with a release layer, for example based on boron nitride (BN), where necessary.

Preferably, the release layer 200", 201", and 202" is positioned in the vicinity of the side wall 2002; 2012; 2022 of the central preform 200 and/or the upper outer preform 201 and/or the lower outer preform 202, so as to prevent infiltration of silicon in the radial R direction, through the disc.

In this variant, after step a6), i.e., after the junction between the preforms 200, 201, 202 has been formed at the carbon barrier layers 200a and/or 200b, 201a and/or 202a, to obtain the preform the band preform 20, the method comprises executing the following steps:

a61) protecting one or more regions of the central preform 200 by means of the previously used release layer 200", e.g., based on boron nitride (BN), or by a different or additional release layer, e.g., based on boron nitride (BN);

a62) infiltrating the upper outer preform 201 and lower outer preform 202 with silicon (Si), in a manner similar to that which is described in step a2). Infiltration with silicon prevents there being space for the aluminum to infiltrate the preform in the infiltration step of the aluminum alloy.

It is obvious that the main difference in this variant of the method lies in executing the silicon infiltration step in the upper outer preform 201 and the lower outer preform 202, after executing the mechanical junction between the lower outer preform and the central preform and between the upper outer preform and the central preform, along the carbon barrier layer.

Therefore, the additional steps, e.g., steps a3), a4) or a5) and all other steps and details of the steps of the method described above, are understood to be equally valid and applicable to this variant of the method, as moreover clearly illustrated in Fig. 2d to 2f.

According to an embodiment of the aforesaid variant of the method, in particular shown in Fig. 2e and 2f, the method comprises an operating step of shielding at least a portion of the upper outer preform 201 and/or the lower outer preform 202 while executing step a3), a4) or a5), for example by placing graphite paper on each portion of the upper or lower outer preform. This allows portions of the upper and/or lower preforms to be shielded so that they may be subsequently infiltrated with silicon Si.

In particular, for example, the method provides for masking at least partially or completely the upper face 2010; 2020 and/or the opposing lower face 2011; 2021, of the upper outer preform 201 and/or the lower outer preform 202.

As may be appreciated from that which has been described, the braking band, the brake disc and the methods for making said brake disc and said braking band according to the invention make it possible to overcome the drawbacks presented in the prior art.

In a particularly innovative manner, in fact, the braking band and brake disc of this invention, by interposing two outer braking bands made of ceramic composite material between the brake pads and the central band made of composite material with an aluminum alloy metal matrix, allows the problems related to local degradation due to overheating of the aluminum, found in the prior art, to be reduced - if not eliminated. In addition, they allow for the simultaneous development of greater braking force, due to the coupling of the pads on a material with a higher friction coefficient. At the same time, efficiency, simplicity, low implementation cost and reduced corrosion problems are ensured. Reduced corrosion is particularly advantageous in electric vehicles, where the introduction of regenerative braking involves discontinuous use of the disc brake, which may lead to corrosive phenomena.

A person skilled in the art, for the purpose of meeting contingent and specific needs, may make numerous modifications and variants to the disc and disc brake described above, all of which, however, are contained within the scope of the invention as defined by the following claims.

**Claims**

1. A method for making a braking band (2) for a brake disc (1) for a disc brake, said method comprising the following steps:

   a) preparing a mold (10) having an inner cavity (11), which comprises a first portion (11a) of a shape corresponding to the braking band (2) to be made;
   b) providing a band preform (20) comprising a central preform (200), an upper outer preform (201) and a lower outer preform (202), said central preform (200) being made of porous ceramic material comprising silicon carbide (SiC), said upper outer preform (201) and lower outer preform (202) being made of porous ceramic material comprising silicon carbide (SiC) and infiltrated with silicon (SiC+Si), wherein a carbon barrier layer (201a, 200a, 200b, 202a) made of carbon is interposed between the upper outer preform (201) and the central preform (200) and between the lower outer preform (202) and the central preform (200), said preforms (200, 201, 202) having the shape of the braking band (2) to be made;
   c) placing said band preform (20) inside the mold at the first portion (11a) of said inner cavity (11); and
   d) injecting a liquid or semi-solid aluminum alloy inside the entire inner cavity (11) of the mold (10) to infiltrate with said aluminum alloy the central preform (200) of said band preform (20) made of porous ceramic material, obtaining at the first portion (11a) an aluminum metal matrix composite reinforced by said central preform (200) which defines the braking band (2) to be made.

2. Method according to claim 1, wherein, before step b), for making the band preform (20) the method comprises the steps of:

   a1) providing a central preform (200), an upper outer preform (201) and a lower outer preform (202), said central preform (200), upper outer preform (201) and lower outer preform (202) each being made of porous ceramic material comprising silicon carbide (SiC);
   a2) infiltrating the upper outer preform (201) and lower outer preform (202) with silicon (Si);
   a3) depositing on the central preform (200) a material in particle form comprising carbon to obtain at least one carbon barrier layer (200a, 200b) made of carbon;
   a4) alternatively to step a3), depositing on the upper outer preform (201) and the lower outer preform (202) a material in particle form comprising carbon to provide at least one carbon barrier layer (201a, 202a) of carbon (C) on each of said upper outer preform (201) and lower outer preform (202);

a5) alternatively to steps a3) and a4), depositing on the central preform (200) and the upper outer preform (201) and/or the lower outer preform (202) a material in particle form comprising carbon to provide at least one carbon barrier layer (200a and/or 200b, 201a and/or 202a) made of carbon (C) on the central preform (200) and the upper outer preform (201) and/or the lower outer preform (202);

a6) joining the central preform (200), the upper outer preform (201) and the lower outer preform (202) together by inserting silicon at each carbon barrier layer (200a and/or 200b, 201a and/or 202a) and heating said preforms (200, 201, 202) until a junction is formed between them at the carbon barrier layers (200a and/or 200b, 201a and/or 202a), resulting in the band preform (20).

3. Method according to claim 1, wherein, before step b), for making the band preform (20) the method comprises the steps of:

a3) depositing on the central preform (200) a material in particle form comprising carbon to obtain at least one carbon barrier layer (200a, 200b) made of carbon;

a4) alternatively to step a3), depositing on the upper outer preform (201) and the lower outer preform (202) a material in particle form comprising carbon to provide at least one carbon barrier layer (201a, 202a) of carbon (C) on each of said upper outer preform (201) and lower outer preform (202);

a5) alternatively to steps a3) and a4), depositing on the central preform (200) and the upper outer preform (201) and/or the lower outer preform (202) a material in particle form comprising carbon to provide at least one carbon barrier layer (200a and/or 200b, 201a and/or 202a) made of carbon (C) on the central preform (200) and the upper outer preform (201) and/or the lower outer preform (202);

a11) protecting one or more regions of the upper outer preform (201), the lower outer preform (202) and the central preform (200) by a release layer (200'', 201'', 202''), e.g., boron nitride (BN) based;

a6) joining the central preform (200), the upper outer preform (201) and the lower outer preform (202) together by inserting silicon at each carbon barrier layer (200a and/or 200b, 201a and/or 202a) and heating said preforms (200, 201, 202) until a junction is formed between them at the carbon barrier layers (200a and/or 200b, 201a and/or 202a);

a61) protecting one or more regions of the central preform (200) by the release layer (200''), e.g., based on Boron Nitride (BN), used in step a11) or by a different or additional release layer, e.g., Boron Nitride (BN) based;

a62) infiltrating the upper outer preform (201) and lower outer preform (202) with silicon (Si).

4. Method according to claim 2 or 3, wherein in step a2) or step a62) the upper outer preform (201) and the lower outer preform (202) are positioned in a crucible coated with a release layer, e.g., Boron Nitride (BN) based, a predetermined amount of powdered silicon (Si) is added to the crucible and the upper outer preform (201) and the lower outer preform (202) are heated to obtain the fusion of the added silicon (Si).

5. Method according to claim 4, wherein the upper outer preform (201) and the lower outer preform (202) is heated to a temperature above the melting temperature of Si (1414°C), at an atmospheric pressure and in an inert atmosphere, preferably under an Argon atmosphere.

6. Method according to any one of the claims from 2 to 5, wherein in step a3) or a4) or a5), the step of depositing a material in particle form comprising carbon to obtain at least one carbon barrier layer (201a, 202a) made of carbon (C) is achieved by Chemical Vapor Deposition or by sputtering or by Physical Vapor Deposition (PVD), or by bonding with graphite-based glue.

7. Method according to claim 6, wherein gaseous methane is used as a carbon precursor for chemical vapor deposition, and wherein the temperature is comprised between 1100°C and 1300°C, the pressure is between 10 and 50 millibars.

8. Method according to claim 7, wherein the contribution of the gas mixture during the chemical vapor deposition step is:

- between 0.4 and 3 standard liters per minute (slm) of methane;
- between 0.2 and 5 standard liters per minute (slm) of hydrogen;
- between 0 and 4 standard liters per minute (slm) of argon;

and where the ratio of methane to hydrogen is comprised between 0.3 and 5.

9. Method according to any one of the claims from 2 to 8, wherein in step a6) the method involves:

- heating the preforms (200, 201, 202) to a temperature of about 1450°C for a time of about 2 hours by interposing a stoichiometric amount of silicon between the preforms defined according to their size.

10. Method according to any one of the preceding claims, wherein step d) of introducing the aluminum alloy inside the mold is performed according to a semi-solid or liquid infiltration technique or by squeeze casting.

11. Method according to any one of the preceding claims, wherein the central preform (200), the lower outer preform (202) and the upper outer preform (201) are obtained by sequentially subjecting to molding, dewaxing and sintering a mass of ceramic material granules superficially coated with a polymeric binding composition.

12. Method according to one or more of the claims from 6 to 10, wherein said sintering is carried out in two separate sintering cycles, wherein a first sintering cycle is carried out at a temperature of not less than 1600°C, preferably about 1800°C, and a second sintering cycle is carried out at a temperature of not less than 2000°C, preferably in the range 2100°C-2200°C, both in an inert atmosphere.

13. Method according to any one of the preceding claims, wherein in step d), the mold closes over the upper outer preform (201) and the lower outer preform (202) so that during the introduction of aluminum into the mold, the infiltration of aluminum over the upper outer preform (201) and under the lower outer preform (202) is prevented, so that the outer braking surfaces (2a,2b) of the disc are free of aluminum.

14. Method for making a brake disc, said brake disc comprising a braking band (2) and a bell (3), said method comprising the following steps:

a) preparing a mold (10) having an inner cavity (11) which comprises a first portion (11a) of a shape corresponding to the braking band (2) of the brake disc (1) to be made, and a second portion (11b) of a shape corresponding to the bell (3) of the brake disc (1) to be made, wherein the first portion (11a) and the second portions (11b) of said inner cavity (11) communicate with each other;

b) providing a band preform (20) comprising a central preform (200), an upper outer preform (201) and a lower outer preform (202), said central preform (200) being made of porous ceramic material comprising silicon carbide (SiC), said upper outer preform (201) and lower outer preform (202) being made of porous ceramic material comprising silicon carbide (SiC) and infiltrated with silicon (SiC+Si), wherein a carbon barrier layer (201a, 200a, 200b, 202a) made of carbon is interposed between the upper outer preform (201) and the central preform (200) and between the lower outer preform (202) and the central preform (200), said preforms (200, 201, 202) having the shape of the braking band (2) of the brake disc (1) to be made;

c) placing said band preform (20) inside the mold at the first portion (11a) of said inner cavity (11); and

d) injecting a liquid or semi-solid aluminum alloy inside the entire inner cavity (11) of the mold (10) so to infiltrate with said aluminum alloy only the central preform (200) of said band preform (20) made of porous ceramic material, obtaining at the first portion (11a) an aluminum metal matrix composite reinforced by said central preform (200) which partially defines the braking band (2) of the brake disc to be made, and to fill with said aluminum alloy the second portion (11b) obtaining an aluminum alloy fusion which is connected in one piece with the braking band (2) made of composite metallic matrix and defines the bell (3) of the brake disc (1) to be made.

15. A braking band (2) for a brake disc for a disc brake, said braking band (2) consisting of:

a central band (200') made of an aluminum metal matrix composite reinforced with ceramic material comprising silicon carbide (SiC), said composite being obtained by infiltrating with an aluminum alloy a central preform (200) made of porous ceramic material of shape corresponding to the braking band,

an upper band (201'), which is joined to the central band (200'), along an upper junction layer (22a), said upper band (201') being made of porous ceramic material comprising silicon carbide (SiC) and infiltrated with silicon (SiC+Si) and covering the central band (200') on one side thereof,

a lower band (202'), which is joined to the central band (200') along a lower junction layer (22b) arranged on the opposite side, i.e. opposite, relative to the upper junction layer (22a), said lower band (202') being made of porous ceramic material comprising silicon carbide (SiC) and infiltrated with silicon (SiC+Si) and covering the central band (200') on the other side, i.e. opposite relative to the upper band (201').

16. Brake disc for a disc brake, comprising a braking band (2) according to claim 15 and a bell (3) connected to said braking band (2).

17. Brake disc for a disc brake according to claim 16, wherein the bell (3) is connected in one piece to the braking band (2) and consists of an aluminum alloy co-casting with the metallic matrix of the composite which constitutes the braking band (2).

18. Brake disc (1) according to claim 16 or 17, wherein the aluminum alloy matrix has a homogeneously distributed structure inside said composite.

**Patentansprüche**

1. Verfahren zur Herstellung eines Bremsbandes (2) für eine Bremsscheibe (1) für eine Scheibenbremse, wobei das Verfahren die folgenden Schritte aufweist:

   a) Vorbereiten einer Form (10), mit einem Innenraum (11), der einen ersten Abschnitt (11a) einer dem herzustellenden Bremsband (2) entsprechenden Form aufweist;
   b) Bereitstellen einer Band-Vorform (20), die eine zentrale Vorform (200), eine obere äußere Vorform (201) und eine untere äußere Vorform (202) aufweist, wobei die zentrale Vorform (200), die aus porösem Keramikmaterial hergestellt ist, das Siliciumcarbid (SiC) aufweist, wobei die obere äußere Vorform (201) und die untere äußere Vorform (202) aus porösem Keramikmaterial hergestellt sind, das Siliciumcarbid (SiC) aufweist und mit Silizium (SiC+Si) infiltriert ist, wobei eine Carbonbarriereschicht (201a, 200a, 200b, 202a), die aus Carbon hergestellt ist, zwischen die obere äußere Vorform (201) und die zentrale Vorform (200) sowie zwischen die untere äußere Vorform (202) und die zentrale Vorform (200) eingefügt ist, wobei die Vorformen (200, 201, 202) die Form des herzustellenden Bremsbandes (2) haben;
   c) Platzieren der Band-Vorform (20) innerhalb der Form an dem ersten Abschnitt (11a) des Innenraums (11); und
   d) Injizieren einer flüssigen oder halbfesten Aluminiumlegierung in den gesamten Innenraum (11) der Form (10), um mit der Aluminiumlegierung die aus porösem Keramikmaterial hergestellte zentrale Vorform (200) der Band-Vorform (20) zu infiltrieren, wobei an dem ersten Abschnitt (11a) ein Aluminium-Metallmatrix-Komposit erhalten wird, das durch die zentralen Vorform (200) verstärkt ist, die das herzustellende Bremsband (2) definiert.

2. Verfahren nach Anspruch 1, wobei vor dem Schritt b) zur Herstellung der Band-Vorform (20) das Verfahren die Schritte aufweist:

   a1) Bereitstellen einer zentralen Vorform (200), einer oberen äußeren Vorform (201) und einer unteren äußeren Vorform (202), wobei die zentrale Vorform (200), die obere äußere Vorform (201) und die untere äußere Vorform (202) jeweils aus einem Siliziumkarbid (SiC) aufweisenden porösem Keramikmaterial hergestellt sind;
   a2) Infiltrieren der oberen äußeren Vorform (201) und der unteren äußeren Vorform (202) mit Silizium (Si);
   a3) Abscheiden auf der zentralen Vorform (200) eines Carbon aufweisendenMaterials in Partikelform, um mindestens eine aus Carbon hergestellte Carbonbarriereschicht (200a, 200b) zu erhalten;
   a4) alternativ zu Schritt a3), Abscheiden auf der oberen äußeren Vorform (201) und der unteren äußeren Vorform (202) eines Carbon aufweisenden Materials in Partikelform, um mindestens eine Carbonbarriereschicht (201a, 202a) aus Carbon (C) auf jeder der oberen äußeren Vorform (201) und der unteren äußeren Vorform (202) bereitzustellen;
   a5) alternativ zu den Schritten a3) und a4), Abscheiden auf der zentralen Vorform (200) und der oberen äußeren Vorform (201) und/oder der unteren äußeren Vorform (202) eines Carbon aufweisenden Materials in Partikelform, um mindestens eine Carbonbarriereschicht (200a und/oder 200b, 201a und/oder 202a), die aus Carbon (C) hergestellt ist, auf der zentralen Vorform (200) und der oberen äußeren Vorform (201) und/oder der unteren äußeren Vorform (202) bereitzustellen;
   a6) Verbinden der zentralen Vorform (200), der oberen äußeren Vorform (201) und der unteren äußeren Vorform (202) miteinander durch Einfügen von Silizium an jeder Carbonbarriereschicht (200a und/oder 200b, 201a und/oder 202a), und Erhitzen der Vorformen (200, 201, 202), bis zwischen diesen an den Carbonbarriereschichten (200a und/oder 200b, 201a und/oder 202a) eine Verbindung gebildet wird, was in der Band-Vorform (20) resultiert.

3. Verfahren nach Anspruch 1, wobei vor dem Schritt b) zur Herstellung der Band-Vorform (20) das Verfahren die Schritte aufweist:

a3) Abscheiden auf der zentralen Vorform (200) eines Carbon aufweisenden Materials in Partikelform zum Erhalt zumindest einer aus Carbon hergestellten Carbonbarriereschicht (200a, 200b);

a4) alternativ zu Schritt a3), Abscheiden auf der oberen äußeren Vorform (201) und der unteren äußeren Vorform (202) eines Carbon aufweisenden Materials in Partikelform, um zumindest eine Carbonbarriereschicht (201a, 202a) aus Carbon (C) auf jeder der oberen äußeren Vorform (201) und der unteren äußeren Vorform (202) bereitzustellen;

a5) alternativ zu den Schritten a3) und a4), Abscheiden auf der zentralen Vorform (200) und der oberen äußeren Vorform (201) und/oder der unteren äußeren Vorform (202) eines Carbon aufweisenden Materials in Partikelform, um zumindest eine aus Carbon (C) hergestellte Carbonbarriereschicht (200a und/oder 200b, 201a und/oder 202a) auf der zentralen Vorform (200) und der oberen äußeren Vorform (201) und/oder der unteren äußeren Vorform (202) bereitzustellen;

a11) Schützen einer oder mehreren Regionen der oberen äußeren Vorform (201), der unteren äußeren Vorform (202) und der zentralen Vorform (200) durch eine Ablöseschicht (200", 201", 202"), z. B. basierend auf Bornitrid (BN);

a6) Verbinden der zentralen Vorform (200), der oberen äußeren Vorform (201) und der unteren äußeren Vorform (202) miteinander durch Einbringen von Silizium an jeder Carbonbarriereschicht (200a und/oder 200b, 201a und/oder 202a), und Erhitzen der Vorformen (200, 201, 202), bis eine zwischen diesen an den Carbonbarriereschichten (200a und/oder 200b, 201a und/oder 202a) Verbindung gebildet wird;

a61) Schützen von einer oder mehreren Regionen der zentralen Vorform (200) durch die in Schritt a11) benutzte Ablöseschicht (200"), z. B. basierend auf Bornitrid (BN), oder durch eine andere oder zusätzliche Ablöseschicht, z. B. basierend auf Bornitrid (BN);

a62) Infiltrieren der oberen äußeren Vorform (201) und der unteren äußeren Vorform (202) mit Silizium (Si).

4. Verfahren nach Anspruch 2 oder 3, wobei in Schritt a2) oder Schritt a62) die obere äußere Vorform (201) und die untere äußere Vorform (202) in einem Tiegel positioniert werden, der mit einer Ablöseschicht, z. B. basierend auf Bornitrid (BN), beschichtet ist, eine vorbestimmte Menge von pulvrigem Silizium (Si) zu dem Tiegel hinzugefügt wird und die obere äußere Vorform (201) und die untere äußere Vorform (202) erhitzt werden, um die Fusion des zugefügten Siliziums (Si) zu erhalten.

5. Verfahren nach Anspruch 4, wobei die obere äußere Vorform (201) und die untere äußere Vorform (202) auf eine Temperatur oberhalb des Schmelzpunkts von Si (1414 °C) erhitzt wird, bei Atmosphärendruck und in einer inerten Atmosphäre, bevorzugt unter einer Argonatmosphäre.

6. Verfahren nach einem der Ansprüche von 2 bis 5, wobei in Schritt a3) oder a4) oder a5) der Schritt zum Abscheiden eines Carbon aufweisenden Materials in Partikelform, zum Erhalt zumindest einer aus Carbon (C) hergestellten Carbonbarriereschicht (201a, 202a), durch chemische Dampfabscheidung oder durch Sputtern oder durch physikalische Dampfabscheidung (PVD) oder durch Verkleben mit Graphit-basiertem Klebstoff erzielt wird.

7. Verfahren nach Anspruch 6, wobei gasförmiges Methan als Carbonvorläufer für chemische Dampfabscheidung benutzt wird, und wobei die Temperatur zwischen 1100 °C und 1300 °C liegt, und der Druck zwischen 10 und 50 Millibar beträgt.

8. Verfahren nach Anspruch 7, wobei der Beitrag des Gasgemischs während des chemischen Dampfabscheidungsschritts ist:

- zwischen 0,4 und 3 Standardliter pro Minute (slm) Methan;
- zwischen 0,2 und 5 Standardliter pro Minute (slm) Wasserstoff;
- zwischen 0 und 4 Standardliter pro Minute (slm) Argon;

und wobei das Verhältnis von Methan zu Wasserstoff zwischen 0,3 und 5 beträgt.

9. Verfahren nach einem der Ansprüche 2 bis 8, wobei in Schritt a6) das Verfahren beinhaltet:

- Erhitzen der Vorformen (200, 201, 202) auf eine Temperatur von etwa 1450 °C für eine Zeit von etwa 2 Stunden durch Einfügen einer stöchiometrischen Siliziummenge zwischen die Vorformen, definiert gemäß ihrer Größe.

10. Verfahren nach einem der vorhergehenden Ansprüche, wobei Schritt d) zum Einführen der Aluminiumlegierung in die Form gemäß einer halbfesten oder Flüssig-Infiltrationstechnik oder durch Squeeze-Casting erfolgt.

11. Verfahren nach einem der vorhergehenden Ansprüche, wobei die zentrale Vorform (200), die untere äußere Vorform (202) und die obere äußere Vorform (201) erhalten werden durch sequentielles Formen, Entwachsen und Sintern einer Masse von Keramikmaterialkörnern, die oberflächlich mit einer Polymer-Bindemittelzusammensetzung beschichtet sind.

12. Verfahren nach einem oder mehreren der Ansprüche 6 bis 10, wobei das Sintern in zwei separaten Sinterzyklen ausgeführt wird, wobei ein erster Sinterzyklus bei einer Temperatur von nicht weniger als 1600 °C, bevorzugt etwa 1800 °C ausgeführt wird, ein zweiter Sinterzyklus bei einer Temperatur von nicht weniger als 2000 °C, bevorzugt im Bereich von 2100 °C bis 2200 °C ausgeführt wird, beide in einer Inert-Atmosphäre.

13. Verfahren nach einem der vorhergehenden Ansprüche, wobei in Schritt d) die Form die obere äußere Vorform (201) und die untere äußere Vorform (202) überschließt, sodass während des Einführens von Aluminium in die Form die Infiltration von Aluminium über die obere äußere Vorform (201) und die untere äußere Vorform (202) verhindert wird, sodass die äußeren Bremsflächen (2a, 2b) der Scheibe frei von Aluminium sind.

14. Verfahren zur Herstellung einer Bremsscheibe, wobei die Bremsscheibe ein Bremsband (2) und eine Glocke (3) aufweist, wobei das Verfahren die folgenden Schritte aufweist:

   a) Vorbereiten einer Form (10) mit einem Innenraum (11), der einen ersten Abschnitt (11a) einer dem Bremsband (2) der herzustellenden Bremsscheibe (1) entsprechenden Form, sowie einen zweiten Abschnitt (11b) einer der Glocke (3) der herzustellenden Bremsscheibe (1) entsprechenden Form aufweist, wobei der erste Abschnitt (11a) und der zweite Abschnitt (11b) des Innenraums (11) miteinander in Verbindung stehen;
   b) Bereitstellen einer Band-Vorform (20), die eine zentrale Vorform (200), eine obere äußere Vorform (201) und eine untere äußere Vorform (202) aufweist, wobei die zentrale Vorform (200) aus porösem Keramikmaterial hergestellt ist, das Siliciumcarbid (SiC) aufweist, wobei die obere äußere Vorform (201) und die untere äußere Vorform (202) aus porösem Keramikmaterial hergestellt sind, das Siliciumcarbid (SiC) aufweist und mit Silizium (SiC+Si) infiltriert ist, wobei eine Carbonbarriereschicht (201a, 200a, 200b, 202a), die aus Carbon hergestellt ist, zwischen die obere äußere Vorform (201) und die zentrale Vorform (200) und zwischen die untere äußere Vorform (202) und die zentrale Vorform (200) eingefügt ist, wobei die Vorformen (200, 201, 202) die Form des herzustellenden Bremsbandes (2) der Bremsscheibe (1) haben;
   c) Platzieren der Band-Vorform (20) innerhalb der Form an dem ersten Abschnitt (11a) des Innenraums (11); und
   d) Injizieren einer flüssigen oder halbfesten Aluminiumlegierung in den gesamten Innenraum (11) der Form (10), um mit der Aluminiumlegierung nur die aus porösem Keramikmaterial hergestellte zentrale Vorform (200) der Band-Vorform (20) zu infiltrieren, wobei an dem ersten Abschnitt (11a) ein Aluminium-Metallmatrix-Komposit erhalten wird, das durch die zentralen Vorform (200) verstärkt ist, die das herzustellende Bremsband (2) teilweise definiert; und um den zweiten Abschnitt (11b) mit der Aluminiumlegierung zum Erhalt einer Aluminiumlegierungsfusion zu füllen, die mit dem aus Kompositmetallmatrix hergestellten Bremsband (2) einstückig verbunden ist, und die Glocke (3) der herzustellenden Bremsscheibe (1) definiert.

15. Bremsband (2) für eine Bremsscheibe einer Scheibenbremse, wobei das Bremsband (2) besteht aus:

   einem zentralen Band (200'), das aus einem Aluminium-Metallmatrix-Komposit hergestellt ist, das mit einem Siliziumkarbid (SiC) aufweisenden Keramikmaterial verstärkt ist, wobei das Komposit erhalten wird durch Infiltrieren einer aus porösem Keramikmaterial hergestellten zentralen Vorform (200) einer dem Bremsband entsprechenden Form, mit einer Aluminiumlegierung,
   einem oberen Band (201'), das mit dem zentralen Band (200') entlang einer oberen Verbindungsschicht (22a) verbunden ist, wobei das obere Band (201') aus porösem Keramikmaterial hergestellt ist, das Siliziumkarbid (SiC) aufweist und mit Silizium (SiC+Si) infiltriert ist und das zentrale Band (200') auf einer Seite davon bedeckt,
   einem unteren Band (202'), das mit dem zentralen Band (200') entlang einer unteren Verbindungsschicht (22b) verbunden ist, die auf der entgegengesetzten Seite, d. h. entgegengesetzt relativ zu der oberen Verbindungsschicht (22a) angeordnet ist, wobei das untere Band (202') aus porösem Keramikmaterial hergestellt ist, das Siliziumkarbid (SiC) aufweist und mit Silizium (SiC+Si) infiltriert ist und das zentrale Band (200') auf der anderen Seite, d. h. entgegengesetzt relativ zu dem oberen Band (201') bedeckt.

16. Bremsscheibe für eine Scheibenbremse, die ein Bremsband (2) nach Anspruch 15 und eine mit dem Bremsband (2) verbundene Glocke (3) aufweist.

17. Bremsscheibe für eine Scheibenbremse nach Anspruch 16, wobei die Glocke (3) mit dem Bremsband (2) einstückig verbunden ist und aus einem Aluminiumlegierung-Co-Casting mit der Metall-Matrix des Komposits besteht, das das Bremsband (2) darstellt.

18. Bremsscheibe (1) nach Anspruch 16 oder 17, wobei die Aluminiumlegierungsmatrix innerhalb des Komposits eine homogen verteilte Struktur hat.

## Revendications

1. Procédé de fabrication d'une bande de freinage (2) pour un disque de frein (1) pour frein à disque, ledit procédé comprenant les étapes suivantes consistant à :

   a) préparer un moule (10) ayant une cavité interne (11), qui comprend une première partie (11a) d'une forme correspondant à la bande de freinage (2) à fabriquer ;
   b) fournir une préforme de bande (20) comprenant une préforme centrale (200), une préforme externe supérieure (201) et une préforme externe inférieure (202), ladite préforme centrale (200) étant faite d'un matériau céramique poreux comprenant du carbure de silicium (SiC), lesdites préforme externe supérieure (201) et préforme externe inférieure (202) étant faites d'un matériau céramique poreux comprenant du carbure de silicium (SiC) et infiltré avec du silicium (SiC + Si), dans lequel une couche barrière en carbone (201a, 200a, 200b, 202a) faite de carbone est intercalée entre la préforme externe supérieure (201) et la préforme centrale (200) et entre la préforme externe inférieure (202) et la préforme centrale (200), lesdites préformes (200, 201, 202) ayant la forme de la bande de freinage (2) à fabriquer ;
   c) placer ladite préforme de bande (20) à l'intérieur du moule au niveau de la première partie (11a) de ladite cavité interne (11) ; et
   d) injecter un alliage d'aluminium liquide ou semi-solide à l'intérieur de la totalité de la cavité interne (11) du moule (10) pour infiltrer avec ledit alliage d'aluminium la préforme centrale (200) de ladite préforme de bande (20) faite d'un matériau céramique poreux, pour obtenir au niveau de la première partie (11a) un composite à matrice en aluminium métallique renforcé par ladite préforme centrale (200) qui définit la bande de freinage (2) à fabriquer.

2. Procédé selon la revendication 1, dans lequel, avant l'étape b), pour fabriquer la préforme de bande (20), le procédé comprend les étapes consistant à :

   a1) fournir une préforme centrale (200), une préforme externe supérieure (201) et une préforme externe inférieure (202), lesdites préforme centrale (200), préforme externe supérieure (201) et préforme externe inférieure (202) étant chacune faites d'un matériau céramique poreux comprenant du carbure de silicium (SiC) ;
   a2) infiltrer la préforme externe supérieure (201) et la préforme externe inférieure (202) avec du silicium (Si) ;
   a3) déposer sur la préforme centrale (200) un matériau sous forme de particules comprenant du carbone pour obtenir au moins une couche barrière en carbone (200a, 200b) faite de carbone ;
   a4) en variante à l'étape a3), déposer sur la préforme externe supérieure (201) et la préforme externe inférieure (202) un matériau sous forme de particules comprenant du carbone pour fournir au moins une couche barrière en carbone (201a, 202a) de carbone (C) sur chacune desdites préforme externe supérieure (201) et préforme externe inférieure (202) ;
   a5) en variante aux étapes a3) et a4), déposer sur la préforme centrale (200) et la préforme externe supérieure (201) et/ou la préforme externe inférieure (202) un matériau sous forme de particules comprenant du carbone pour fournir au moins une couche barrière en carbone (200a et/ou 200b, 201a et/ou 202a) faite de carbone (C) sur la préforme centrale (200) et la préforme externe supérieure (201) et/ou la préforme externe inférieure (202) ;
   a6) joindre ensemble la préforme centrale (200), la préforme externe supérieure (201) et la préforme externe inférieure (202) en insérant du silicium au niveau de chaque couche barrière en carbone (200a et/ou 200b, 201a et/ou 202a) et en chauffant lesdites préformes (200, 201, 202) jusqu'à ce qu'une jonction se forme entre elles au niveau des couches barrières en carbone (200a et/ou 200b, 201a et/ou 202a), ce qui donne la préforme de bande (20).

3. Procédé selon la revendication 1, dans lequel, avant l'étape b), pour fabriquer la préforme de bande (20), le procédé comprend les étapes consistant à :

   a3) déposer sur la préforme centrale (200) un matériau sous forme de particules comprenant du carbone pour obtenir au moins une couche barrière en carbone (200a, 200b) faite de carbone ;
   a4) en variante à l'étape a3), déposer sur la préforme externe supérieure (201) et la préforme externe inférieure (202) un matériau sous forme de particules comprenant du carbone pour fournir au moins une couche barrière en carbone (201a, 202a) de carbone (C) sur chacune desdites préforme externe supérieure (201) et préforme externe inférieure (202) ;

a5) en variante aux étapes a3) et a4), déposer sur la préforme centrale (200) et la préforme externe supérieure (201) et/ou la préforme externe inférieure (202) un matériau sous forme de particules comprenant du carbone pour fournir au moins une couche barrière en carbone (200a et/ou 200b, 201a et/ou 202a) faite de carbone (C) sur la préforme centrale (200) et la préforme externe supérieure (201) et/ou la préforme externe inférieure (202) ;

a11) protéger une ou plusieurs régions de la préforme externe supérieure (201), de la préforme externe inférieure (202) et de la préforme centrale (200) par une couche antiadhésive (200", 201", 202"), par exemple à base de nitrure de bore (BN) ;

a6) joindre ensemble la préforme centrale (200), la préforme externe supérieure (201) et la préforme externe inférieure (202) en insérant du silicium au niveau de chaque couche barrière en carbone (200a et/ou 200b, 201a et/ou 202a) et en chauffant lesdites préformes (200, 201, 202) jusqu'à ce qu'une jonction se forme entre elles au niveau des couches barrières en carbone (200a et/ou 200b, 201a et/ou 202a) ;

a61) protéger une ou plusieurs régions de la préforme centrale (200) par la couche antiadhésive (200"), par exemple à base de nitrure de bore (BN), utilisée dans l'étape a11) ou par une couche antiadhésive différente ou supplémentaire, par exemple à base de nitrure de bore (BN) ;

a62) infiltrer la préforme externe supérieure (201) et la préforme externe inférieure (202) avec du silicium (Si).

4. Procédé selon la revendication 2 ou 3, dans lequel, dans l'étape a2) ou dans l'étape a62), la préforme externe supérieure (201) et la préforme externe inférieure (202) sont positionnées dans un creuset revêtu d'une couche antiadhésive, par exemple à base de nitrure de bore (BN), une quantité prédéterminée de silicium (Si) pulvérulent est ajoutée dans le creuset et la préforme externe supérieure (201) et la préforme externe inférieure (202) sont chauffées pour obtenir la fusion du silicium (Si) ajouté.

5. Procédé selon la revendication 4, dans lequel la préforme externe supérieure (201) et la préforme externe inférieure (202) sont chauffées à une température supérieure à la température de fusion du Si (1414 °C), à pression atmosphérique et dans une atmosphère inerte, de préférence sous une atmosphère d'argon.

6. Procédé selon l'une quelconque des revendications 2 à 5, dans lequel dans l'étape a3) ou a4) ou a5), l'étape de dépôt d'un matériau sous forme de particules comprenant du carbone pour obtenir au moins une couche barrière en carbone (201a, 202a) faite de carbone (C) est réalisée par dépôt chimique en phase vapeur ou par pulvérisation cathodique ou par dépôt physique en phase vapeur (PVD), ou par collage avec une colle à base de graphite.

7. Procédé selon la revendication 6, dans lequel du méthane gazeux est utilisé comme précurseur de carbone pour le dépôt chimique en phase vapeur, et dans lequel la température est comprise entre 1100 °C et 1300 °C, la pression est entre 10 et 50 millibars.

8. Procédé selon la revendication 7, dans lequel la contribution du mélange gazeux lors de l'étape de dépôt chimique en phase vapeur est :

- entre 0,4 et 3 litres standards par minute (slm) de méthane ;
- entre 0,2 et 5 litres standards par minute (slm) d'hydrogène ;
- entre 0 et 4 litres standards par minute (slm) d'argon ;

et où le rapport méthane sur hydrogène est compris entre 0,3 et 5.

9. Procédé selon l'une quelconque des revendications 2 à 8, dans lequel dans l'étape a6), le procédé implique :

- le chauffage des préformes (200, 201, 202) à une température d'environ 1450 °C pendant une durée d'environ 2 heures en interposant une quantité stoechiométrique de silicium entre les préformes définie en fonction de leur taille.

10. Procédé selon l'une quelconque des revendications précédentes, dans lequel l'étape d) d'introduction de l'alliage d'aluminium à l'intérieur du moule est réalisée selon une technique d'infiltration semi-solide ou liquide ou par moulage sous pression.

11. Procédé selon l'une quelconque des revendications précédentes, dans lequel la préforme centrale (200), la préforme externe inférieure (202) et la préforme externe supérieure (201) sont obtenues en soumettant séquentiellement à un moulage, un décirage et un frittage une masse de granulés de matériau céramique revêtus superficiellement d'une composition de liant polymère.

12. Procédé selon une ou plusieurs des revendications 6 à 10, dans lequel ledit frittage est effectué dans deux cycles de frittage séparés, dans lequel un premier cycle de frittage est effectué à une température de pas moins de 1600 °C, de préférence d'environ 1800 °C, et un second cycle de frittage est effectué à une température de pas moins de 2000 °C, de préférence dans la plage de 2100 °C à 2200 °C, tous deux dans une atmosphère inerte.

13. Procédé selon l'une quelconque des revendications précédentes, dans lequel dans l'étape d), le moule se ferme sur la préforme externe supérieure (201) et la préforme externe inférieure (202) de sorte que pendant l'introduction de l'aluminium dans le moule, l'infiltration d'aluminium sur la préforme externe supérieure (201) et sous la préforme externe inférieure (202) est empêchée, de sorte que les surfaces externes de freinage (2a, 2b) du disque sont exemptes d'aluminium.

14. Procédé de fabrication d'un disque de frein, ledit disque de frein comprenant une bande de freinage (2) et une cloche (3), ledit procédé comprenant les étapes suivantes consistant à :

a) préparer un moule (10) ayant une cavité interne (11) qui comprend une première partie (11a) d'une forme correspondant à la bande de freinage (2) du disque de frein (1) à fabriquer, et une seconde partie (11b) d'une forme correspondant à la cloche (3) du disque de frein (1) à fabriquer, dans lequel la première partie (11a) et les secondes parties (11b) de ladite cavité interne (11) communiquent entre elles ;
b) fournir une préforme de bande (20) comprenant une préforme centrale (200), une préforme externe supérieure (201) et une préforme externe inférieure (202), ladite préforme centrale (200) étant faite d'un matériau céramique poreux comprenant du carbure de silicium (SiC), lesdites préforme externe supérieure (201) et préforme externe inférieure (202) étant faites d'un matériau céramique poreux comprenant du carbure de silicium (SiC) et infiltré avec du silicium (SiC + Si), dans lequel une couche barrière en carbone (201a, 200a, 200b, 202a) faite de carbone est intercalée entre la préforme externe supérieure (201) et la préforme centrale (200) et entre la préforme externe inférieure (202) et la préforme centrale (200), lesdites préformes (200, 201, 202) ayant la forme de la bande de freinage (2) du disque de frein (1) à fabriquer ;
c) placer ladite préforme de bande (20) à l'intérieur du moule au niveau de la première partie (11a) de ladite cavité interne (11) ; et
d) injecter un alliage d'aluminium liquide ou semi-solide à l'intérieur de la totalité de la cavité interne (11) du moule (10) pour infiltrer avec ledit alliage d'aluminium uniquement la préforme centrale (200) de ladite préforme de bande (20) faite d'un matériau céramique poreux, pour obtenir au niveau de la première partie (11a) un composite à matrice en aluminium métallique renforcé par ladite préforme centrale (200) qui définit partiellement la bande de freinage (2) du disque de frein à fabriquer, et pour remplir avec ledit alliage d'aluminium la seconde partie (11b) en obtenant une fusion d'alliage d'aluminium qui est reliée d'un seul tenant à la bande de freinage (2) faite d'une matrice métallique composite et définit la cloche (3) du disque de frein (1) à fabriquer.

15. Bande de freinage (2) pour disque de frein pour frein à disque, ladite bande de freinage (2) consistant en :

une bande centrale (200') faite d'un composite à matrice métallique en aluminium renforcé par un matériau céramique comprenant du carbure de silicium (SiC), ledit composite étant obtenu par l'infiltration avec un alliage d'aluminium d'une préforme centrale (200) faite d'un matériau céramique poreux d'une forme correspondant à la bande de freinage,
une bande supérieure (201'), qui est jointe à la bande centrale (200'), le long d'une couche de jonction supérieure (22a), ladite bande supérieure (201') étant faite d'un matériau céramique poreux comprenant du carbure de silicium (SiC) et infiltrée avec du silicium (SiC+Si) et recouvrant la bande centrale (200') sur un côté de celle-ci,
une bande inférieure (202'), qui est jointe à la bande centrale (200') le long d'une couche de jonction inférieure (22b) agencée sur le côté opposé, c'est-à-dire opposé par rapport à la couche de jonction supérieure (22a), ladite bande inférieure (202') étant faite d'un matériau céramique poreux comprenant du carbure de silicium (SiC) et infiltré avec du silicium (SiC+Si) et recouvrant la bande centrale (200') sur l'autre côté, c'est-à-dire à l'opposé par rapport à la bande supérieure (201').

16. Disque de frein pour frein à disque, comprenant une bande de freinage (2) selon la revendication 15 et une cloche (3) reliée à ladite bande de freinage (2).

**17.** Disque de frein pour frein à disque selon la revendication 16, dans lequel la cloche (3) est reliée d'un seul tenant à la bande de freinage (2) et consiste en un alliage d'aluminium co-moulé avec la matrice métallique du composite qui constitue la bande de freinage (2).

**18.** Disque de frein (1) selon la revendication 16 ou 17, dans lequel la matrice en alliage d'aluminium présente une structure répartie de manière homogène à l'intérieur dudit composite.

FIG.1

FIG.2

FIG.2a

EP 4 298 074 B1

FIG.2b

FIG.2c

EP 4 298 074 B1

FIG.2d

FIG.2e

FIG.2f

EP 4 298 074 B1

20

201

200

202

FIG.3

FIG.4

EP 4 298 074 B1

FIG.5

FIG.6

FIG.7

**EP 4 298 074 B1**

**Patent documents cited in the description**

- WO 2019123222 A1
- US 2016108980 A1